# EUROPÄISCHE PATENTSCHRIFT

(11) **EP 0 751 569 B1**
(45) Veröffentlichungstag und Bekanntmachung des Hinweises auf die Patenterteilung: **26.03.2003**
(21) Anmeldenummer: 96109051.1
(22) Anmeldetag: 05.06.1996
(51) Int. Cl.: H01L 25/16, H01L 23/367, H01L 23/373

(54) **Leistungshybridschaltung**
Hybrid power circuit
Circuit hybride de puissance

(30) Priorität: 26.06.1995 DE 29510336 U
(43) Veröffentlichungstag der Anmeldung: 02.01.1997
(73) Patentinhaber: TYCO Electronics Logistics AG, 9323 Steinach (CH)
(72) Erfinder: Kaindl, Michael, 81739 München (DE); Frisch, Michael, 81379 München (DE)
(74) Vertreter: Klunker . Schmitt-Nilson . Hirsch

(56) Entgegenhaltungen:
- EP-A- 0 013 314
- US-A- 3 860 949
- US-A- 4 650 107
- US-A- 5 410 449
- PATENT ABSTRACTS OF JAPAN vol. 017, no. 579 (E-1451), 21. Oktober 1993 & JP 05 175380 A (SANYO ELECTRIC CO LTD), 13. Juli 1993
- PATENT ABSTRACTS OF JAPAN vol. 006, no. 025 (E-094), 13. Februar 1982 & JP 56 146256 A (TOSHIBA CORP), 13. November 1981

## Beschreibung

Die Erfindung betrifft eine hybridintegrierte Schaltung mit einem plattenförmigen Trägersubstrat, das auf einer Hauptfläche mindestens mit einem Schaltungselement mit hoher Verlustleistung bestückt ist und an dessen gegenüberliegender Hauptfläche ein großflächiger Kühlkörper mittels einer wärmeleitenden Zwischenschicht befestigt ist.

Derartige Leistungshybridschaltungen befinden sich bereits auf dem Markt.

Schichtschaltungen sind Subbaugruppen von elektronischen Geräten, die beispielsweise wie elektrische Bauelemente auf vorhandene Flachbaugruppen gelötet werden und damit zu einer Miniaturisierung der Geräte führen. Als Substratmaterial können Aluminiumoxidplatten oder Siliziumwafer verwendet werden, auf die dann verschiedenartigste Bauelemente hybridiert werden. Die Verdrahtung zwischen diesen Komponenten geschieht über spezielle Schichttechnologien: Durch Siebdruck aufgebrachte Strukturen (Dickschichttechnologie) bzw. durch Vakuumverfahren aufgebrachte dünne Metallschichten mit nachfolgender Fotolithographie (Dünnfilmtechnologie). Eine Besonderheit der Schichtschaltungen ist die Implizierung von integrierten Schichtwiderständen. Ein genereller Vorteil derartiger Schichtschaltungen ist, daß Spannungs- und Leistungsspitzen leichter zu beherrschen sind als bei integrierten Schaltungen.

Bei Schichtschaltungen mit hoher Verlustleistung muß auf dem Trägersubstrat ein Kühlkörper oder Kühlblech zum Abführen der thermischen Verlustleistung befestigt werden. Bisher wird dazu der Kühlkörper ganzflächig mit Klebstoff oder mit Lot versehen. Dies kann beispielsweise durch ganzflächigen Siebdruck geschehen. Das ganzflächige Aufbringen ist jedoch zum einen deshalb problematisch, da unerwünschte Hohlräume (Lunker) durch Lufteinschlüsse entstehen, die nicht entweichen können. Außerdem wäre in Hinsicht auf einen guten Wärmeübergang eine dünne Zwischenschicht wünschenswert. Für eine durchgängige Klebefläche darf die Schichtdicke jedoch schon deshalb nicht zu dünn gewählt werden, da dies bei etwa vorhandenen Unebenheiten zu Problemen führen würde. Eine dünne durchgängige Klebefläche würde im übrigen den Einsatz ausreichend starker und entsprechend beschädigungsträchtiger Kräfte voraussetzen, um die Klebemasse beim Zusammendrücken am Rand herauszupressen. Bisher werden deshalb die Schaltungen unter Verwendung teurer Bauteile und eines aufwendigen Aufbaues so großzügig dimensioniert, daß der relativ schlechte Wärmeübergang ausreicht.

Aus der JP 56 146 256 A (mit Abstract) ist eine hybridintegrierte Schaltung nach dem Oberbegriff des Anspruchs 1 bekannt, bei der die Zwischenschicht von zwei Ecken des rechteckigen Substrats ausgehend bis zu einer Stelle reicht, die etwas über die Lage des Schaltungselements hinausgeht. Damit ist die Zwischenschicht noch beträchtlich groß, ihre Fläche entspricht einem Vielfachen der Fläche der Schattung.

Aufgabe der Erfindung ist es, eine Leistungshybridschaltung der eingangs genannten Art zu schaffen, bei der sich ohne zusätzlichen Aufwand ein besserer Wärmeübergang ergibt.

Erfindungsgemäß wird dies bei einer Leistungshybridschaltung der eingangs genannten Art dadurch erreicht, daß die Zwischenschicht nur bereichsweise an unterhalb der jeweiligen Verlustleister befindlichen Stellen vorgesehen ist.

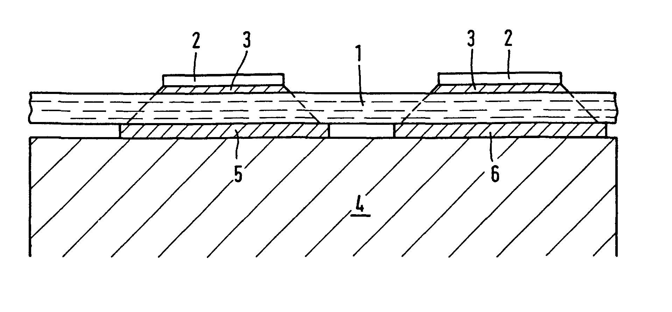

Ausgestaltungen der Erfindung sind in den Unteransprüchen gekennzeichent. Nachfolgend wird ein Ausführungsbeispiel der Erfindung anhand der einzigen Figur der Zeichnung, die eine geschnittene Seitenansicht einer Leistungshybridschaltung zeigt, näher erläutert.

In der Figur ist ein keramisches Aluminiumoxid-Trägersubstrat 1 dargestellt, auf dem mit Abstand zueinander zwei Leistungschips 2 mittels Lot 3 befestigt sind. Die Chips 2 können in beliebiger Weise mit den in der Figur nicht erkennbaren, aber auf der oberen Hauptfläche des Trägersubstrats 1 vorhandenen Widerstands- bzw. Leitungsbahnen verbunden sein. An der unteren Hauptfläche des Trägersubstrats 1 ist mittels einer Zwischenschicht aus Kleber bzw. Lot ein Kühlblech 4 befestigt, das einen wesentlichen Teil des Trägersubstrats 1 überdeckt.

Aus der Figur geht hervor, daß die unterhalb der beiden Chips 2 aufgebrachten Zwischenschichtbereiche 5,6 flächenmäßig jeweils nur wenig größer als die zugehörigen Verlustleister 2 selbst sind. Die Verlustleister, die beispielsweise auch durch Widerstände gebildet sein können, weisen typischerweise eine Fläche von ca. 60 bis 100 mm² auf. Die Zwischenschichtbereiche 5,6 weisen eine Dicke von nur etwa 20 bis 50 µm auf, während früher mehr als 50 µm üblich waren. Derartig dünne Klebeschichten sind beispielsweise mit dem Q1-9226 Kleber der Firma Dow-Corney realisierbar und gewährleisten einen verbesserten Wärmeübergang in Verbindung mit einem ausreichenden mechanischen Halt.

Das Kühlblech 4 bzw. das Trägersubstrat 1 wird, wie dargestellt, im wesentlichen nur an den Punkten mit Klebstoff bzw. Lot bedruckt, an welchen die Verlustleistung abgeführt werden muß. Dadurch werden die einzelnen Klebe- bzw. Lotflächen kleiner und es entstehen weniger Lufteinschlüsse. Durch die Räume zwischen den Zwischenschichtbereichen 5,6 kann beim Anpressen der Kleber bzw. das Lot ausweichen, so daß eine dünnere Zwischenschicht auf einfache Weise möglich wird. Aufgrund dieser Dynamik läßt sich eine optimale Dicke der Zwischenschicht ohne starke Preßkräfte erreichen.

Ein weiterer Vorteil der erfindungsgemäßen Leistungsschichtschaltung besteht fertigungsseitig in der kostengünstigen Einsparung von Kleber bzw. Lot. Außerdem ergibt sich durch die erfindungsgemäße partielle Fügetechnik die Möglichkeit, einzelne, von den Zwischenschichtbereichen 5,6 relativ weit entfernte Punkte auf dem Substrat teilweise von der Kühlblechtemperatur zu entkoppeln. Dadurch können empfindliche Bauteile vor der Abwärme der Verlustleister 2 geschützt werden. Die Erfindung ist außer bei Schichtschaltungen auch bei Schaltungen mit IMS-(Aluminium Polyimid Kupfer) oder DCB-AlTi₂O₃ (Direct Copper Bonding)-Substraten anwendbar.

## Patentansprüche

1. Hybridintegrierte Schaltung mit einem plattenförmigen Trägersubstrat (1), das auf einer Hauptfläche mindestens mit einem Schaltungselement (2) mit hoher Verlustleistung bestückt ist und an dessen gegenüberliegender Hauptfläche ein großflächiger Kühlkörper (4) mittels einer wärmeleitenden Zwischenschicht befestigt ist,
**dadurch gekennzeichnet, daß**
mehrere Schaltungselemente vorgesehen sind, und daß die Zwischenschicht aus Zwischenschichtbereichen (5, 6) besteht, die unterhalb der jeweiligen Schaltungselemente (2) vorgesehen sind, wobei jeder der Zwischenschichtbereiche (5, 6) sich im wesentlichen auf den Bereich unterhalb des jeweiligen Schaltungselements beschränkt und sich kontinuierlich über diesen Bereich erstreckt.

2. Schaltung nach Anspruch 1,
**dadurch gekennzeichnet, daß**
die Zwischenschichtbereiche (5, 6) eine Dicke von etwa 20 bis 50 µm aufweisen.

3. Schaltung nach Anspruch 1 oder 2,
**dadurch gekennzeichnet, daß**
die Fläche des jeweiligen Zwischenschichtbereichs größer ist als die Fläche des zugehörigen Schaltungselements.

## Claims

1. Hybrid integrated circuit comprising a plate-shaped carrier substrate (1), which on a main surface is fitted with at least one high power loss circuit element (2), and on the opposite main surface of which a large-surface heat dissipator (4) is secured by means of a heat-conducting intermediate layer, **characterised in that** several circuit elements are foreseen, and **in that** the intermediate layer consists of intermediate layer regions (5, 6), which are provided below the circuit elements (2) in each case, whereby each intermediate layer region (5, 6) is essentially limited to the region below the circuit element in each case and steadily extends over this region.

2. Circuit according to claim 1, **characterised in that** the intermediate layer regions (5, 6) display a thickness of approximately 20 to 50 µm.

3. Circuit according to claims 1 or 2, **characterised in that** the surface of each intermediate layer region is greater than the surface of the corresponding circuit element.

## Revendications

1. Circuit hybride intégré comportant un substrat de support en forme de plaque (1), une surface principale correspondante comportant un élément de circuit (2) à dissipation de puissance élevée et une surface principale opposée comportant un corps de refroidissement de grande surface (4), fixé par l'intermédiaire d'une couche intermédiaire à conductivité thermique, **caractérisé en ce qu'**il comporte plusieurs éléments de circuit, la couche intermédiaire étant composée de zones de couche intermédiaire (5, 6), agencées au-dessous des éléments de circuit (2) respectifs, chacune des zones de la couche intermédiaire (5, 6) étant limitée pour l'essentiel à la région située au-dessous de l'élément de circuit correspondant et s'étendant en continu au-dessus de cette région.

2. Circuit selon la revendication 1, **caractérisé en ce que** les zones de la couche intermédiaire (5, 6) ont une épaisseur comprise entre environ 20 et 50 µm.

3. Circuit selon les revendications 1 ou 2, **caractérisé en ce que** la surface des zones respectives de la couche intermédiaire est supérieure à la surface de l'élément de circuit correspondant.
